# EUROPEAN PATENT SPECIFICATION

(11) **EP 3 528 287 B1**
(45) Date of publication and mention of the grant of the patent: **14.10.2020**
(21) Application number: 17910211.6
(22) Date of filing: 03.08.2017
(51) Int. Cl.: H01L 27/14, H01L 27/144, H01L 25/16

(54) **PHOTOSENSITIVE DETECTION ELEMENT CAPABLE OF DETECTING SPECTRA IN DIFFERENT WAVELENGTHS AT THE SAME TIME**
LICHTEMPFINDLICHES DETEKTIONSELEMENT MIT FÄHIGKEIT ZUR GLEICHZEITIGEN DETEKTION VON SPEKTREN IN VERSCHIEDENEN WELLENLÄNGEN
ÉLÉMENT DE DÉTECTION PHOTOSENSIBLE CAPABLE DE DÉTECTER DES SPECTRES DANS DIFFÉRENTES LONGUEURS D'ONDE EN MÊME TEMPS

(30) Priority: 15.05.2017 WO PCT/CN2017/084387
(43) Date of publication of application: 21.08.2019
(73) Proprietor: Hytronik Electronics Co., Ltd., Huizhou, Guangdong 516023 (CN)
(72) Inventor: CHENG, Yabing, Huizhou Guangdong 516023 (CN)
(74) Representative: Meyer, Thorsten
(86) International application number: PCT/CN2017/095896
(87) International publication number: WO 2018/209821

(56) References cited:
- WO-A1-2014/007734
- CN-A- 1 619 823
- CN-A- 101 106 125
- CN-A- 106 461 462
- CN-C- 100 541 792
- US-A1- 2011 267 610
- US-A1- 2016 249 810

## Description

### FIELD OF THE INVENTION

The present invention relates to the field of electronic devices, more particularly to a photosensitive detecting device capable of simultaneously detecting the spectra of different wavelengths, which is capable of simultaneously detecting various spectra of different wavelengths by one individual device. The document US2016/249810A is a closely related prior art.

### BACKGROUND OF THE INVENTION

Photosensitive sensors are widely used for electronic products such as solar lawn lamps, optical-control night lamps, cameras, monitors, light-activated toys, voice and light control switches, video cameras, anti-theft wallets, light-activated musical boxes, musical birthday candles, musical cups, human body induction lamps and human body sensor switches in the field of automatic optical control. Photoelectric sensors, which convert optical signals into electrical signals by means of photosensitive elements, have sensitive wavelengths including infrared wavelength and ultraviolet wavelengths near wavelengths of visible light. Usually, photosensitive sensors can precisely detect lights having wavelengths in a certain range, but meanwhile have poor effect on the detection of lights having wavelengths in other ranges. Since the ambient light usually consists of lights having the spectra at different wavelengths, conventional photosensitive sensors realize different accuracies in the mornings than in the evenings. In the meantime, in order to realize automatic control, sometimes the detection of invisible light is also necessary. Hence, in order to precisely detect the ambient light or detect lights having different wavelengths, existing products have to be arranged simultaneously with two or more photosensitive sensors for the spectra of different wavelengths and thus have to be provided with a plurality of openings, which lead to high cost and imperfect appearance.

### SUMMARY OF THE INVENTION

In order to overcome disadvantages of existing technologies, the present invention aims to provide a photosensitive detecting device capable of simultaneously detecting the spectra of different wavelengths, which is capable of simultaneously detecting various spectra of different wavelengths by one individual device.

To achieve the above goal, the present invention provides a photosensitive detecting device as recited in claim 1. Further advantageous embodiments are recited in the dependent claims.

According to the present invention, two or more than two photosensitive chips for detecting the spectra of corresponding wavelengths are packaged in one device, and respective spectral filtering layers for allowing light with corresponding wavelengths in the spectra to pass through are provided on respective photosensitive chips, such that different photosensitive chips can be used for detecting the spectra of corresponding wavelengths in different ranges, whereby the present invention achieves the goal of simultaneously detecting the spectra of different wavelengths by one individual device, greatly reducing material cost and the space for PCB, solving the problem of providing the products with a plurality of openings for detecting ambient lights in practical application, and having a very vast market foreground.

### BRIEF DESCRIPTION OF THE DRAWINGS

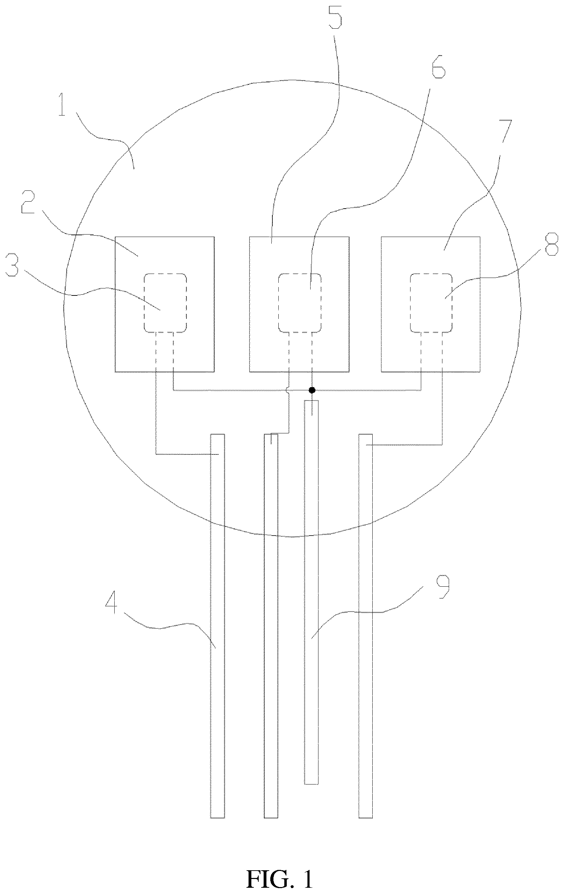

FIG.1 is a schematic drawing illustrating a structure according to an embodiment of the present invention.

### DETAILED DESCRIPTION OF ILLUSTRATED EMBODIMENTS

The present invention will be further explained below in detail with reference to drawings and embodiments.

Referring to FIG.1, a photosensitive detecting device capable of simultaneously detecting the spectra of different wavelengths comprises a first photosensitive chip 3 covered by a first spectral filtering layer 2, the first spectral filtering layer 2 allowing a light with a wavelength in a first range to pass through in response to a reception from the first photosensitive chip 3, a second photosensitive chip 6 covered by a second spectral filtering layer 5, the second spectral filtering layer 5 allowing a light with a wavelength in a second range to pass through in response to a reception from the second photosensitive chip 6, and a third photosensitive chip 8 covered by a third spectral filtering layer 7, the third spectral filtering layer 7 allowing a light with a wavelength in a third range to pass through in response to a reception from the third photosensitive chip 8. Herein, the first photosensitive chip 3, the second photosensitive chip 6 and the third photosensitive chip 8 are arranged on a same printed circuit board 1, respectively covering the first spectral filtering layer 2, the second spectral filtering layer 5 and the third spectral filtering layer 7, and then the packaging is performed.

The present photosensitive detecting device has three photosensitive chips 3, 6 and 8 (in other embodiments two, or four, or more chips may be provided, depending on how many ranges the wavelengths of lights to be detected fall in) for detecting spectra of corresponding wavelengths, which are arranged on the printed circuit board 1 of one individual device and a package can be formed. In addition, the spectral filtering layers 2, 5 and 7 for allowing light with corresponding wavelengths in the spectra to pass through are provided on the surfaces of the three photosensitive chips 3, 6 and 8. Consequently, different photosensitive chips can be used for detecting the spectra of different wavelengths. During manufacturing, common terminals of respective photosensitive chips are connected together inside the device and then led out by one pin 9, and the other pins 4 of respective photosensitive chips are led out separately. Then, an independent photosensitive detecting device can be packaged, which is capable of simultaneously detecting the spectra of different wavelengths by one independent device. It greatly reduces material cost and the space for PCB, solves the problem of providing the products with a plurality of openings for detecting ambient lights in practical application, and has a very vast market foreground.

Referring to FIG.1, in particular in an embodiment of the photosensitive detecting device capable of simultaneously detecting the spectra of different wavelengths on the basis of the above mentioned solution, the first spectral filtering layer 2 may be configured to allow visible light with wavelengths in a range of 400nm-700nm to pass through, and the second spectral filtering layer 5 may be configured to allow invisible light with wavelengths in a range of 700nm-1050nm to pass through.

Referring to FIG.1, in particular in an embodiment of the photosensitive detecting device capable of simultaneously detecting the spectra of different wavelengths on the basis of the above mentioned solution, in order to facilitate identification of pins, the common terminal pin 9 of respective photosensitive chips may be shorter than the other pins 4 of respective photosensitive chips, or, respective pins of respective photosensitive chips may be produced in different colors, so as to facilitate identification during using.

In particular in an embodiment of the photosensitive detecting device capable of simultaneously detecting the spectra of different wavelengths on the basis of the above mentioned solution, the package may be DIP package, or SMD package, or others.

The above description for the photosensitive detecting device capable of simultaneously detecting the spectra of different wavelengths of the present invention is intended to aid in the understanding of the present invention.

## Claims

1. A photosensitive detecting device capable of simultaneously detecting spectra of different wavelengths, wherein the photosensitive detecting device comprises a first photosensitive chip (3) covered by a first spectral filtering layer (2), the first spectral filtering layer (2) allowing a light with a wavelength in a first range to pass through in response to a reception from the first photosensitive chip (3), and at least a second photosensitive chip (6) covered by a second spectral filtering layer (5), the second spectral filtering layer (5) allowing a light with a wavelength in a second range to pass through in response to a reception from the second photosensitive chip (6);
**characterised in that** common terminals of the first photosensitive chip (3) and the second photosensitive chip (6) are connected together inside the device and led out by one pin (9), and respective other terminals (4) of the first photosensitive chip (3) and the second photosensitive chip (6) are led out separately, so as to form a package of an independent photosensitive detecting device.

2. The photosensitive detecting device capable of simultaneously detecting spectra of different wavelengths according to claim 1, **characterized in that**, the first photosensitive chip (3) and the second photosensitive chip (6) are arranged on one same printed circuit board (1), respectively covering the first spectral filtering layer (2) and the second spectral filtering layer (5), so as to form a package.

3. The photosensitive detecting device capable of simultaneously detecting spectra of different wavelengths according to claim 1, **characterized in that**, the first spectral filtering layer (2) and the second spectral filtering layer (5) are configured to allow lights having wavelengths in different ranges to pass through.

4. The photosensitive detecting device capable of simultaneously detecting spectra of different wavelengths according to claim 1, **characterized in that**, the first spectral filtering layer (2) is configured to allow visible lights with wavelengths in a range of 400nm-700nm to pass through, and the second spectral filtering layer (5) is configured to allow invisible lights with wavelengths in a range of 700nm-1050nm to pass through.

5. The photosensitive detecting device capable of simultaneously detecting spectra of different wavelengths according to claim 2, **characterized in that**, the package is DIP package or SMD package.

6. The photosensitive detecting device capable of simultaneously detecting spectra of different wavelengths according to claim 1, **characterized in that**, a third photosensitive chip (8) covered by a third spectral filtering layer (7) is further provided, the third spectral filtering layer (7) allowing a light with a wavelength in a third range to pass through in response to a reception from the third photosensitive chip (8).

7. The photosensitive detecting device capable of simultaneously detecting spectra of different wavelengths according to claim 6, **characterized in that**, the first photosensitive chip (3), the second photosensitive chip (6) and the third photosensitive chip (8) are arranged on one same printed circuit board (1), respectively covering the first spectral filtering layer (2), the second spectral filtering layer (5) and the third spectral filtering layer (7), so as to form a package.

8. The photosensitive detecting device capable of simultaneously detecting spectra of different wavelengths according to claim 6, **characterized in that**, the first spectral filtering layer (2), the second spectral filtering layer (5) and the third spectral filtering layer (7) are configured to allow lights having wavelengths in different ranges to pass through.

9. The photosensitive detecting device capable of simultaneously detecting spectra of different wavelengths according to claim 6, **characterized in that**, common terminals of the first photosensitive chip (3), the second photosensitive chip (6) and the third photosensitive chip (8) are connected together inside the device and led out by one same pin (9), and respective other terminals (4) of the first photosensitive chip (3), the second photosensitive chip (6) and the third photosensitive chip (8) are led out separately, so as to form a package of an independent photosensitive detecting device.

## Patentansprüche

1. Lichtempfindliche Detektionsvorrichtung, die fähig ist, gleichzeitig Spektren unterschiedlicher Wellenlängen zu erkennen, wobei die lichtempfindliche Detektionsvorrichtung einen ersten lichtempfindlichen Chip (3), der von einer ersten Spektralfilterschicht (2) bedeckt ist, wobei die erste Spektralfilterschicht (2) Licht mit einer Wellenlänge in einem ersten Bereich als Reaktion auf einen Empfang vom ersten lichtempfindlichen Chip (3) hindurchtreten lässt, und mindestens einen zweiten lichtempfindlichen Chip (6) umfasst, der von einer zweiten Spektralfilterschicht (5) bedeckt ist, wobei die zweite Spektralfilterschicht (5) Licht mit einer Wellenlänge in einem zweiten Bereich als Reaktion auf einem Empfang vom zweiten lichtempfindlichen Chip (6) hindurchtreten lässt;
**dadurch gekennzeichnet, dass** gemeinsame Anschlüsse des ersten lichtempfindlichen Chips (3) und des zweiten lichtempfindlichen Chips (6) im Inneren der Vorrichtung miteinander verbunden sind und durch einen Pin (9) herausgeleitet werden und jeweilige andere Anschlüsse (4) des ersten lichtempfindlichen Chips (3) und des zweiten lichtempfindlichen Chips (6) getrennt herausgeleitet werden, um ein Chipgehäuse einer unabhängigen lichtempfindlichen Detektionsvorrichtung zu bilden.

2. Lichtempfindliche Detektionsvorrichtung nach Anspruch 1, die fähig ist, gleichzeitig Spektren unterschiedlicher Wellenlängen zu erkennen, **dadurch gekennzeichnet, dass** der erste lichtempfindliche Chip (3) und der zweite lichtempfindliche Chip (6) auf derselben gedruckten Leiterplatte (1) angeordnet sind und jeweils die erste Spektralfilterschicht (2) bzw. die zweite Spektralfilterschicht (5) abdecken, um ein Chipgehäuse zu bilden.

3. Lichtempfindliche Detektionsvorrichtung nach Anspruch 1, die fähig ist, gleichzeitig Spektren unterschiedlicher Wellenlängen zu erkennen, **dadurch gekennzeichnet, dass** die erste Spektralfilterschicht (2) und die zweite Spektralfilterschicht (5) ausgelegt sind, Licht mit Wellenlängen in unterschiedlichen Bereichen hindurchtreten zu lassen.

4. Lichtempfindliche Detektionsvorrichtung nach Anspruch 1, die fähig ist, gleichzeitig Spektren unterschiedlicher Wellenlängen zu erkennen, **dadurch gekennzeichnet, dass** die erste Spektralfilterschicht (2) ausgelegt ist, sichtbares Licht mit Wellenlängen in einem Bereich von 400 nm-700 nm hindurchtreten zu lassen, und die zweite Spektralfilterschicht (5) ausgelegt ist, unsichtbares Licht mit Wellenlängen in einem Bereich von 700 nm-1050 nm hindurchtreten zu lassen.

5. Lichtempfindliche Detektionsvorrichtung nach Anspruch 2, die fähig ist, gleichzeitig Spektren unterschiedlicher Wellenlängen zu erkennen, **dadurch gekennzeichnet, dass** das Chipgehäuse ein DIP-Gehäuse oder ein SMD-Gehäuse ist.

6. Lichtempfindliche Detektionsvorrichtung nach Anspruch 1, die fähig ist, gleichzeitig Spektren unterschiedlicher Wellenlängen zu erkennen, **dadurch gekennzeichnet, dass** ferner ein dritter lichtempfindlicher Chip (8) vorgesehen ist, der von einer dritten Spektralfilterschicht (7) bedeckt ist, wobei die dritte Spektralfilterschicht (7) Licht mit einer Wellenlänge in einem dritten Bereich als Reaktion auf einen Empfang vom dritten lichtempfindlichen Chip (8) hindurchtreten lässt.

7. Lichtempfindliche Detektionsvorrichtung nach Anspruch 6, die fähig ist, gleichzeitig Spektren unterschiedlicher Wellenlängen zu erkennen, **dadurch gekennzeichnet, dass** der erste lichtempfindliche Chip (3), der zweite lichtempfindliche Chip (6) und der dritte lichtempfindliche Chip (8) auf derselben gedruckten Leiterplatte (1) angeordnet sind und jeweils die erste Spektralfilterschicht (2), die zweite Spektralfilterschicht (5) bzw. die dritte Spektralfilterschicht (7) abdecken, um ein Chipgehäuse zu bilden.

8. Lichtempfindliche Detektionsvorrichtung nach Anspruch 6, die fähig ist, gleichzeitig Spektren unterschiedlicher Wellenlängen zu erkennen, **dadurch gekennzeichnet, dass** die erste Spektralfilterschicht (2), die zweite Spektralfilterschicht (5) und die dritte Spektralfilterschicht (7) ausgelegt sind, Licht mit Wellenlängen in unterschiedlichen Bereichen hindurchtreten zu lassen.

9. Lichtempfindliche Detektionsvorrichtung nach Anspruch 6, die fähig ist, gleichzeitig Spektren unterschiedlicher Wellenlängen zu erkennen, **dadurch gekennzeichnet, dass** gemeinsame Anschlüsse des ersten lichtempfindlichen Chips (3), des zweiten lichtempfindlichen Chips (6) und des dritten lichtempfindlichen Chips (8) im Inneren der Vorrichtung miteinander verbunden sind und durch einen selben Pin (9) herausgeleitet werden und jeweilige andere Anschlüsse (4) des ersten lichtempfindlichen Chips (3), des zweiten lichtempfindlichen Chips (6) und des dritten lichtempfindlichen Chips (8) getrennt herausgeleitet werden, um ein Chipgehäuse einer unabhängigen lichtempfindlichen Detektionsvorrichtung zu bilden.

## Revendications

1. Dispositif de détection photosensible capable de détecter simultanément des spectres de différentes longueurs d'onde, dans lequel le dispositif de détection photosensible comprend une première puce photosensible (3) recouverte d'une première couche de filtrage spectral (2), la première couche de filtrage spectral (2) permettant à une lumière ayant une longueur d'onde dans une première gamme de passer à travers en réponse à une réception de la première puce photosensible (3), et au moins une deuxième puce photosensible (6) recouverte d'une deuxième couche de filtrage spectral (5), la deuxième couche de filtrage spectral (5) permettant à une lumière ayant une longueur d'onde dans une deuxième gamme de passer en réponse à une réception de la deuxième puce photosensible (6) ;
**caractérisé en ce que** des bornes communes de la première puce photosensible (3) et de la deuxième puce photosensible (6) sont connectées ensemble à l'intérieur du dispositif et sorties par une broche (9), et les autres bornes respectives (4) de la première puce photosensible (3) et de la deuxième puce photosensible (6) sont guidées à l'extérieur séparément, de manière à former un ensemble d'un dispositif de détection photosensible indépendant.

2. Dispositif de détection photosensible capable de détecter simultanément des spectres de différentes longueurs d'onde selon la revendication 1, **caractérisé en ce que** la première puce photosensible (3) et la deuxième puce photosensible (6) sont disposées sur une même carte de circuit imprimé (1), recouvrant respectivement la première couche de filtrage spectral (2) et la deuxième couche de filtrage spectral (5), de manière à former un ensemble.

3. Dispositif de détection photosensible capable de détecter simultanément des spectres de différentes longueurs d'onde selon la revendication 1, **caractérisé en ce que** la première couche de filtrage spectral (2) et la deuxième couche de filtrage spectral (5) sont configurées pour permettre le passage de lumières ayant des longueurs d'onde dans différentes gammes.

4. Dispositif de détection photosensible capable de détecter simultanément des spectres de différentes longueurs d'onde selon la revendication 1, **caractérisé en ce que** la première couche de filtrage spectral (2) est configurée pour permettre le passage de lumières visibles ayant des longueurs d'onde dans une gamme de 400 à 700 nm, et la deuxième couche de filtrage spectral (5) est configurée pour permettre le passage de lumières invisibles ayant des longueurs d'onde dans une gamme de 700 à 1050 nm.

5. Dispositif de détection photosensible capable de détecter simultanément des spectres de différentes longueurs d'onde selon la revendication 2, **caractérisé en ce que**, l'ensemble est un ensemble DIP ou un ensemble SMD.

6. Dispositif de détection photosensible capable de détecter simultanément des spectres de différentes longueurs d'onde selon la revendication 1, **caractérisé en ce que**, une troisième puce photosensible (8) recouverte d'une troisième couche de filtrage spectral (7) est en outre prévue, la troisième couche de filtrage spectral (7) permettant le passage d'une lumière ayant une longueur d'onde dans une troisième gamme en réponse à une réception de la troisième puce photosensible (8).

7. Dispositif de détection photosensible capable de détecter simultanément des spectres de différentes longueurs d'onde selon la revendication 6, **caractérisé en ce que**, la première puce photosensible (3), la deuxième puce photosensible (6) et la troisième puce photosensible (8) sont disposées sur une même carte de circuit imprimé (1), recouvrant respectivement la première couche de filtrage spectral (2), la deuxième couche de filtrage spectral (5) et la troisième couche de filtrage spectral (7), de manière à former un ensemble.

8. Dispositif de détection photosensible capable de détecter simultanément des spectres de différentes longueurs d'onde selon la revendication 6, **caractérisé en ce que**, la première couche de filtrage spectral (2), la deuxième couche de filtrage spectral (5) et la troisième couche de filtrage spectral (7) sont configurées pour permettre le passage de lumières ayant des longueurs d'onde dans différentes gammes.

9. Dispositif de détection photosensible capable de détecter simultanément des spectres de différentes longueurs d'onde selon la revendication 6, **caractérisé en ce que** des bornes communes de la première puce photosensible (3), de la deuxième puce photosensible (6) et de la troisième puce photosensible (8) sont connectées ensemble à l'intérieur du dispositif et guidées vers l'extérieur par une même broche (9), et les autres bornes respectives (4) de la première puce photosensible (3), de la deuxième puce photosensible (6) et de la troisième puce photosensible (8) sont guidées vers l'extérieur séparément, de manière à former un ensemble d'un dispositif de détection photosensible indépendant.
